# EUROPEAN PATENT APPLICATION

(11) **EP 2 282 348 A2**
(43) Date of publication of application: **09.02.2011**
(21) Application number: 10171439.2
(22) Date of filing: 30.07.2010
(51) Int. Cl.: H01L 29/78, H01L 29/06, H01L 29/24

(54) **Silicon carbide semiconductor structures, devices, and methods for making the same**

(30) Priority: 31.07.2009 US 533712
(71) Applicant: General Electric Company, Schenectady, NY 12345 (US)
(72) Inventor: Losee, Peter Almern, Clifton Park, NY 12065 (US); Arthur, Stephen Daley, Glenville, NY 12302 (US); Brown, Dale Marius, Niskayuna, NY 12309 (US); Matocha, Kevin Sean, Rexford, NY 12148 (US); Rao, Ravinuthala Ramakrishna, 560067 Bangalore (IN)
(74) Representative: Gray, Thomas

(57) **Abstract**

There are provided semiconductor structures (100) and devices (200) comprising silicon carbide (SiC) and methods for making the same. The structures (100) and devices (200) comprise a base or shielding layer (216), channel (218) and surface layer (220), all desirably formed via ion implantation. As a result, the structures and devices provided herein are hard, "normally off" devices, i.e., exhibiting threshold voltages of greater than about 3 volts.

## Description

### BACKGROUND

The present disclosure relates to silicon carbide MOS semiconductor structures and devices, such as a field-effect transistors, and methods of making these.

Silicon carbide (SiC) inversion mode MOSFETs have very low channel mobilities caused by excessive electron trapping due to SiC/SiO₂ interface traps and surface scattering. Instead of achieving the expected value of 250 cm²/v-sec, only 15 to 20 cm²/v-sec are typically achieved in conventional SiC inversion mode MOSFETs.

Moving to a buried channel FET structure wherein much of the conduction is subsurface can alleviate low mobility problems. However, such devices usually have low threshold voltages between 1 and 3 volts at room temperature - not high enough to provide the desired noise immunity and a "hard" off state, especially at higher temperatures.

In efforts to provide increased threshold voltages, much research has been focused on higher work function gate materials. For example many buried channel devices utilize heavily doped p+ polysilicon gate electrodes. But this material, even though it has a higher work function than molybdenum or n+ polysilicon, only provides a threshold increase of about 0.4 volts. Further, although the use of, e.g., p+ SiC, or even p type diamond films, as gate electrode materials is expected to increase the threshold by about 1.4 volts and 3 volts respectively, it has yet to be demonstrated that these two complex materials can be properly fabricated to be used as gate electrodes over thin SiO₂ gate dielectrics.

Thus, there remains a need for normally-off buried channel SiC MOSFETs with a sufficiently high threshold voltage for power switching applications. The advantages of such a device could be further leveraged if it could be practically and simply manufactured.

### BRIEF DESCRIPTION

A silicon carbide semiconductor FET structure is provided. The structure comprises a drift layer having a first conductivity type, an ion implanted base or shielding structure having a second conductivity type overlying at least a portion of the drift layer, an ion implanted channel of the first conductivity type within the base or shielding structure, and an ion implanted surface layer of the second conductivity type overlying at least a portion of the base or shielding structure.

Also provided are silicon carbide semiconductor devices comprising a semiconductor structure having a drift layer having a first conductivity type, an ion implanted base or shielding structure having a second conductivity type within the first conductivity type, an ion implanted channel of the first conductivity type within the base or shielding structure, and an ion implanted surface layer of the second conductivity type overlying at least a portion of the base or base or shielding structure. The device further comprises a dielectric and then a gate conductor located on a portion of said ion-implanted surface layer and a source region and a drain region, which are in contact with at least said ion-implanted channel.

Methods of making a semiconductor structure are also provided. The methods comprise providing a drift layer having a first conductivity type and ion implanting a base or shielding layer having a second conductivity type, ion implanting a channel within the base or shielding layer having the first conductivity type, and ion implanting a surface layer overlying at least a portion of the base or base or shielding structure and having the second conductivity type.

### DRAWINGS

There follows a detailed description of embodiments of the invention by way of example only with reference to the accompanying drawings, in which:
FIG. 1 is a cross-sectional view of a semiconductor structure according to one embodiment;
FIG. 2A is a partial cross-sectional view of a conventional semiconductor device;
FIG. 2B is a partial cross-sectional view of a semiconductor device according to one embodiment;
FIG. 3A is a graphical depiction of logarithmic dopant concentration versus the distance from the surface for a conventional semiconductor device;
FIG. 3B is a graphical depiction of logarithmic dopant concentration versus the distance from the surface for conventional buried channel semiconductor device;
FIG. 3C is a graphical depiction of logarithmic dopant concentration versus the distance from the surface for a semiconductor device according to one embodiment; and
FIG 4 is a graphical depiction of the calculated transfer characteristics of MOSFET devices in accordance with one embodiment of the present invention.

### DETAILED DESCRIPTION

Unless defined otherwise, technical and scientific terms used herein have the same meaning as is commonly understood by one of skill in the art to which this invention belongs. The terms "first", "second", and the like, as used herein do not denote any order, quantity, or importance, but rather are used to distinguish one element from another. Also, the terms "a" and "an" do not denote a limitation of quantity, but rather denote the presence of at least one of the referenced item, and the terms "front", "back", "bottom", and/or "top", unless otherwise noted, are merely used for convenience of description, and are not limited to any one position or spatial orientation. If ranges are disclosed, the endpoints of all ranges directed to the same component or property are inclusive and independently combinable (e.g., ranges of "up to about 25 wt.%, or, more specifically, about 5 wt.% to about 20 wt.%," is inclusive of the endpoints and all intermediate values of the ranges of "about 5 wt.% to about 25 wt.%," etc.). The modifier "about" used in connection with a quantity is inclusive of the stated value and has the meaning dictated by the context (e.g., includes the degree of error associated with measurement of the particular quantity).

It will be understood that when an element such as a layer, region or drift layer is referred to as being "on" or "over" another element, it can be directly on the other element, or, intervening elements may be present. On the other hand, when an element is referred to as being "directly on" or "directly over" another element, there are no intervening elements present. Likewise, when an element is referred to as being "beneath" or "under" another element, it can be directly beneath or under the other element, or intervening elements may be present. In contrast, when an element is referred to as being "directly beneath" or "directly under" another element, there are no intervening elements present.

There is provided herein a silicon carbide semiconductor structure. The structure comprises a drift layer having a first conductivity type, a base or shielding structure having a second conductivity type overlying at least a portion of the drift layer, a channel of the first conductivity type within the base or shielding structure, and a surface layer of the second conductivity type overlying at least a portion of the base or shielding structure. The base or shielding structure, surface layer and channel are desirably formed via ion implantation, and as a result, and as compared to providing such layers by other methods, such as e.g., by epitaxial growth, very fine control is possible over the thickness and charge concentration of each layer. As a result, the charge tradeoff of these layers may be manipulated to provide the desired threshold voltage and/or amount of buried channel conduction.

Any p-doped feature(s) within the structure or device may comprise any p-type dopant (i.e., an element from column III of the Periodic table of elements), while the dopant present in any n-doped feature(s) may be any n-type dopant (i.e., an element from column V of the Periodic Table of elements). When more than one feature of the semiconductor structure or device comprises the p-dopant(s), the p-dopant(s) may be the same or different. In certain embodiments, the p-type dopant(s) may comprise, for example, aluminum or boron or combinations of these. Similarly, when more than one features of the semiconductor structure or device comprises the n-dopant(s), the n-dopant(s) may be the same or different. In certain embodiments, the n-type dopant(s) may comprise, for example phosphorous or nitrogen.

The base or shielding layer will desirably be highly doped, i.e., will comprise a sufficient dopant concentration so that the device has lower reverse leakage current and/or the device will not exhibit substantial punchthrough breakdown at high drain voltages. More particularly, the base or shielding layer will desirably comprise a dopant density of from about 2×10¹³cm⁻² to about 2×10¹⁴cm⁻², or from about 3×10¹³cm⁻² to about 1.8×10¹⁴cm⁻², or even from about 7.5×10¹³cm⁻² to about 1.5x10¹⁴cm⁻². On the other hand, the channel may desirably comprise dopant densities from about 1×10¹²cm⁻² to about 8×10¹²cm⁻², or from about 2×10¹²cm⁻² to about 7.5×10¹²cm⁻², or even from about 2×10¹²cm⁻² to about 7×10¹²cm⁻². Appropriate dopant densities for the surface layer can range from about 1×10¹¹cm⁻² to about 4×10¹²cm⁻², or from about 1×10¹¹cm⁻² to about 3×10¹²cm⁻², or even from about 1×10¹¹cm⁻² to about 2.5×10¹²cm⁻².

The surface layer, utilized to control the threshold of the device as required to maintain low channel in the offstate, will desirably be relatively shallow, i.e., will be from about 0.05cm to about 0.1µm from the surface of the structure or device so that existing ion implantation technology may advantageously be utilized in forming the surface layer.

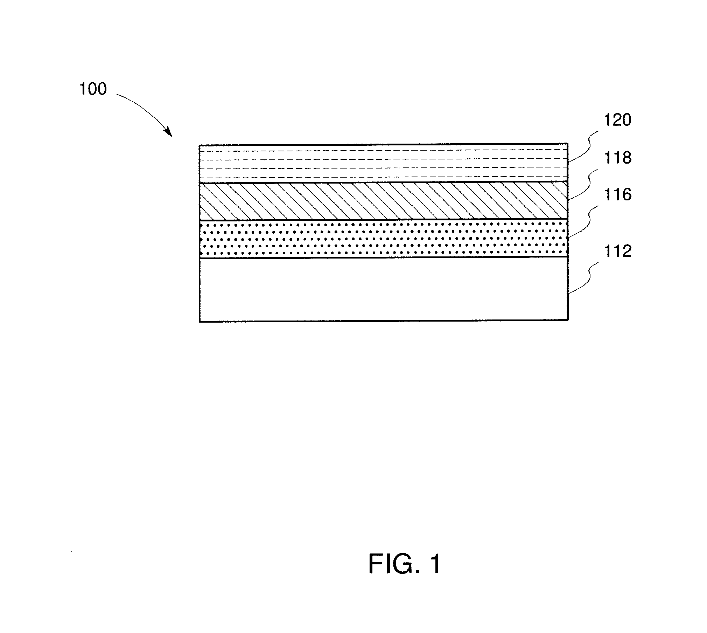

The present semiconductor structure may be further described with reference to one embodiment of the same shown in FIG. 1. More particularly, semiconductor structure 100 includes drift layer 112, appropriate for the voltage range. Lightly doped drift layer 112 can be epitaxially deposited, if desired, and has formed thereupon p-doped base or shielding layer 116, an n-doped channel layer 118 located on an upper surface of base or shielding layer 116, and a p-doped surface layer 120 located on an upper surface of the n-doped channel layer 118.

In an alternate embodiment (not shown), base or shielding layer 116 may be n-doped, channel layer 118 may be p-doped, and surface layer 120 may be n-doped. Drift layer 112 may comprise any semiconductor material, and desirably comprises silicon carbide. Drift layer 112 may be doped, undoped, or may contain doped and undoped regions therein.

Each of the individual layers 116, 118 and 120 are thin (providing a total thickness of less than about 1 micron). Generally, base or shielding layer 116 will have a thickness of from about 0.1µm to about 0.7 µm, with a thickness of from about 0.25µm to about 0.6µm being more typical. Channel layer 118 of the inventive structure will typically have a thickness of from about 0.05µm to about 0.25µm, or from about 0.1µm to about 0.15µm. The thickness of the surface layer 120 typically between about 0.05µm and about 0.1µm. Thickness of the surface layer, 120, is defined as the distance from the semiconductor and insulator to metallurgical junction formed by the surface layer and n-channel layer. Thickness of the channel layer, 118, is defined as the distance from the metallurgical junction formed by the surface layer and n-channel layer to the metallurgical junction formed by channel layer and base or shielding layer. Thickness of the base or shielding layer, 116, is defined as the distance from the metallurgical junction formed by the channel layer and base or shielding layer to the metallurgical junction formed by base or shielding layer and the drift layer.

The semiconductor structure described herein may be provided in connection with any other desired components or features in order to make a functioning semiconductor device. It has now been shown that such devices can be normally off, with a high enough threshold voltage (e.g., greater than about 3V, greater than 4V, or even greater than about 5V) to reduce or even substantially prevent off-state channel leakage. Stated another way, devices in accordance with such embodiments allow the device to operate in a buried channel or inversion mode, and/or optimization of the normally-off threshold voltage versus the transconductance.

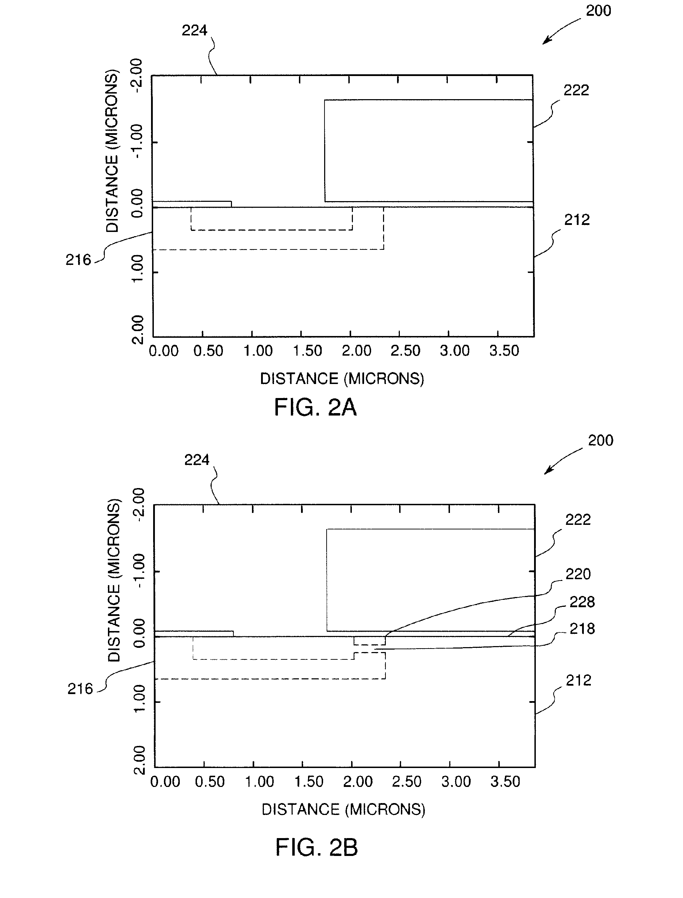

For example, the semiconductor structure may be provided in connection with a gate oxide/dielectric and gate conductor and source and drain regions, to form a portion of a lateral or vertical MOSFET, etc. One example of semiconductor device in accordance with this embodiment is shown, in partial cross-sectional view, in FIG 2B, and may be further understood with reference to FIG. 2A, which shows, in partial cross-sectional view, a conventional MOSFET.

More particularly, FIGs 2A and 2B show a partial cross section of vertical MOSFET 200, comprising drift layer 212, p-doped base or shielding layer 216, n-doped channel layer 218, and in the instance of the inventive device shown in FIG. 2B, p-doped surface layer 220, i.e., channel layer 218 is buried in the inventive device shown in FIG. 2B. Each of MOSFETs 200 shown in FIGs 2A and 2B further comprise dielectric 228, gate 222 and passivation layer 224. It is expected, that by providing device 200 shown in 2B with buried channel layer 218 and surface layer 220, that this device will exhibit enhanced mobilities of from about 60 cm²/V-sec to about 100 cm²/V-sec as compared to mobilities of from about 10 cm²/V-sec to about 15 cm²/V-sec exhibited by conventional inversion mode FET structures or devices, such as that shown in FIG. 2A. As with the disclosed semiconductor structure, in an additional embodiment of the present semiconductor device, base or shielding layer 216 may be n-doped, channel layer 218 may be p-doped, and surface layer 220 may be n-doped.

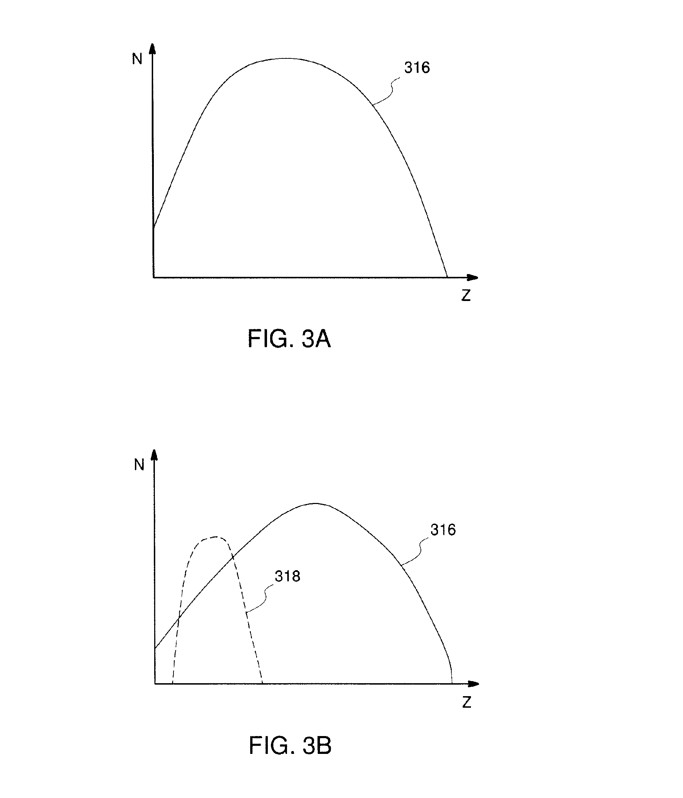

FIGs 3A-3C are graphical depictions of the logarithmic dopant concentration versus distance from the surface for a conventional device such as that shown in FIG 2A, and a device as described herein. More particularly, FIG. 3A is a graphical depiction of the conventional doping profile of an ion implanted base or shielding layer 316 having a second conductivity type using single or multiple energy sources into a drift layer (not shown) having a first conductivity type in a conventional (inversion mode Double Implanted-MOSFET) device. In the conventional device, the base or shielding layer needs to shield the junction formed by the second and first conductivity type for higher voltages, as well as provide the optimal threshold voltage to form an inversion mode channel region.

In FIG 3B, a channel layer 318 of a first conductivity type is ion implanted into the base or shielding layer 316 of the second conductivity type. The addition of the channel layer, avoids the threshold voltage dependence on the base or shielding layer 316. And so, by adjusting the doping of the channel layer 318, a range of conduction modes are possible, namely, threshold adjusted inversion mode conduction, depletion mode conduction or buried conduction.

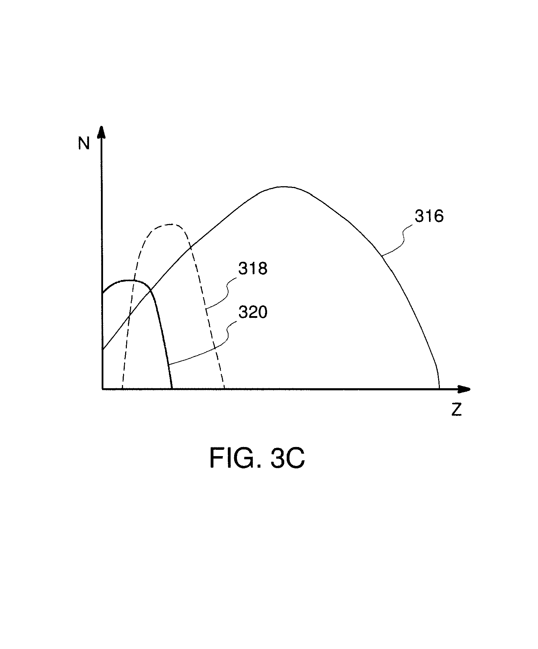

In Figure 3C, a surface layer 320 of the second conductivity type is provided. With the addition of this surface layer, one can now tailor the device from normally off inversion mode to normally off buried conduction mode, as well as tailoring the devices' transconductance from the typically low values observed in inversion mode to higher values seen in buried channel devices.

As mentioned above, the base or shielding layer, channel, and surface layer are desirably formed via ion implantation. Ion implantation allows more control of thickness and/or dopant concentration than other fabrication methods, and as a result, offers more flexibility in charge tradeoff in the present base or shielding layer, channel and surface layer, and thus, more control over the threshold voltage and amount of buried channel conduction. Also, ion implantation is a practical fabrication technique already used in many facets of semiconductor manufacture, and as a result, the present methods will be easily implemented in many manufacturing settings.

As such, also provided herein are methods for making a semiconductor structure comprising providing a drift layer having a first conductivity type, and ion implanting thereupon a base or shielding layer having a second conductivity type. A channel having the first conductivity type is ion implanted within the base or shielding layer, and a surface layer having the second conductivity type is ion implanted so as to overlie at least a portion of the base or shielding layer.

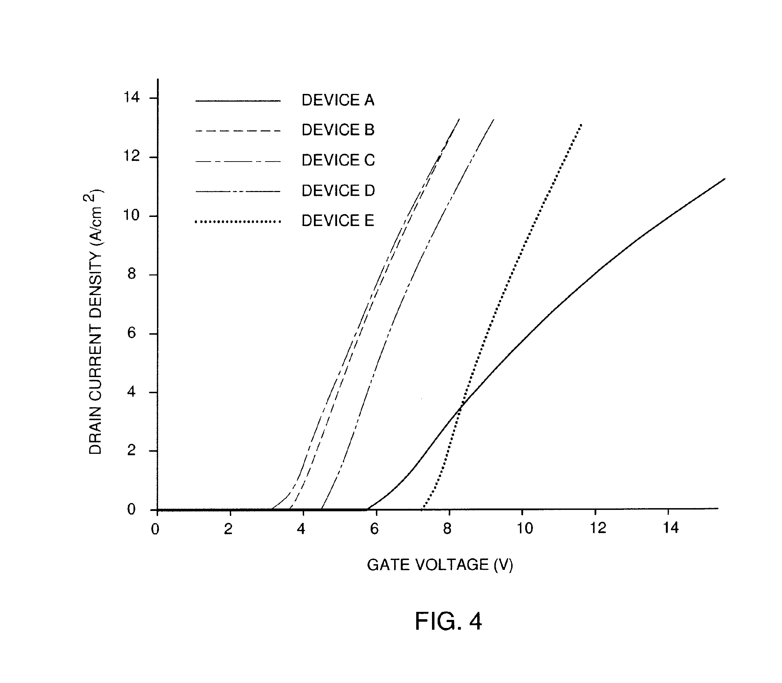

FIG. 4 is a graphical representation of calculated drain current density versus gate voltage characteristics of embodiments of the present invention. As used herein, the term "threshold voltage" refers to the voltage given by the X-intercept of the linear fit to the drain current versus gate voltage characteristics of a MOSFET device. Transconductance is obtained by differentiating the drain current versus gate voltage characteristics of a MOSFET device. Device A (comparative) is an inversion mode device where is only p-well layer is present in the channel. Devices B, C, D and E are devices according to embodiments of the invention described herein, wherein a base or shielding layer, channel layer and surface layers are all present in the channel region. All of these devices have the same channel length, i.e. 0.5µm. Devices D and E have similar base or shielding layer and channel layer dopant concentrations.

Device E has a higher surface dopant concentration and thus, a higher threshold voltage than device D. Devices E and C have similar base or shielding layer and surface layer dopant concentrations. But, device C has a higher channel dopant concentration and thus, a lower threshold voltage than device E. Maximum transconductance for the devices C, D and E are 3.7 siemens/cm², 4.3 siemenS/Cm² and 4.5 siemens/cm², respectively. The dopant concentrations of each layer of the devices according to embodiments of the devices described herein are shown in Table 1, below.

**TABLE 1**

| Device | P_{shielding} | N_{channel} | P_{surface} |
|---|---|---|---|
| A (Comparative) | -- | -- | -- |
| B | 9e13/cm² | 3e12/cm² | 1e12/cm² |
| C | 12e13/cm² | 6e12/cm² | 2.25e12/cm² |
| D | 12e13/cm² | 3e12/cm² | 1e12/cm² |
| E | 12e13/cm² | 3e12/cm² | 2.25e12/cm² |

As shown in FIG. 4, Device A has an offstate of over 5 V, and a gradual slope indicating low conductance. In contrast, Devices B, C, D and E all give greater transconductance, with Device E giving the greatest threshold voltage, thus illustrating that by utilizing the principles disclosed herein, the off voltage versus transconductance can be tailored depending on the particular desired application.

The deposition of each of the base or shielding layer, channel and surface layer may be formed in the same or different apparatus. The ion implantation is carried out using p- or n- dopant precursors that are well known to those of ordinary skill in the art. In some embodiments, a graded layer may be provided, i.e., the concentration of the dopant throughout the thickness of the layer can be caused to vary.

Further, because the surface layer is relatively shallow, low implantation energies may be utilized to form the same, i.e., implantation energies of from about 25keV to about 100keV. Or, the surface layer may be implanted through a "screen" oxide layer. Well known to those of ordinary skill in the art, screen oxides are one example of a sacrificial layer. Such layers have no direct function in the completed structure or device and thus, are typically disposed of after use. In implantation, these oxides are provided at a given thickness to absorb some of the implanted dopants and cause net reduction of the penetration depth of the dopants, thus assisting in shallow implantations.

While only certain features of the invention have been illustrated and described herein, many modifications and changes will occur to those skilled in the art. It is, therefore, to be understood that the appended claims are intended to cover all such modifications and changes as fall within the true spirit of the invention.

## Claims

1. A silicon carbide semiconductor FET structure (100) comprising a drift layer (112) having a first conductivity type, an ion implanted base or shielding structure (116) having a second conductivity type within the drift layer, an ion implanted channel (118) of the first conductivity type within the base or shielding structure (116), and an ion implanted surface layer (120) of the second conductivity type overlying at least a portion of the base or shielding structure (116).

2. The silicon carbide semiconductor structure of claim 1, wherein the base or shielding layer comprises a dopant density of from about 2×10¹³cm⁻² to about 2×10¹⁴cm⁻².

3. The silicon carbide semiconductor structure of claim 2, wherein the base or shielding layer comprises a dopant density of from about 7.5×10¹³cm⁻² to about 1.5c10¹⁴cm⁻².

4. The silicon carbide semiconductor structure of claim 1, wherein the dopant utilized in the base or shielding layer and the surface layer are the same.

5. The silicon carbide semiconductor structure of claim 1, wherein the dopant utilized in the base or shielding layer and the surface layer are different.

6. The silicon carbide semiconductor structure of claim 1, wherein the dopant utilized in the base or shielding layer and/or the surface layer comprises aluminum or boron.

7. The silicon carbide semiconductor structure of claim 1, wherein the channel comprises a dopant concentration of from about 1×10¹¹cm⁻² to about 8×10¹²cm⁻² atoms/cm².

8. The silicon carbide semiconductor structure of claim 5, wherein the dopant utilized in the ion-implanted n-doped channel comprises phosphorous or nitrogen.

9. A silicon carbide semiconductor device (200) comprising:
a drift layer (212) having a first conductivity type and having an upper surface;
a structure comprising an ion implanted base or shielding structure (216) within the drift layer (212) having a second conductivity type, an ion implanted channel (218) of the first conductivity type within the base or shielding structure (216), and an ion implanted surface layer (220) of the second conductivity type overlying at least a portion of the base or shielding structure (216);
a dielectric (228) located on a portion of said surface layer (220);
a gate conductor (222) overlying at least a portion of the dielectric (228); and
a source contact and a drain contact which are in contact with at least said channel.

10. The silicon carbide semiconductor device of claim 9, wherein the base or shielding layer comprises a dopant density of from about 2×10¹³cm⁻² to about 2×10¹⁴cm⁻².

11. The silicon carbide semiconductor device of claim 9 or 10, having a threshold voltage of greater than about 3 volts.

12. The silicon carbide semiconductor device of any of claims 9 to 11, wherein the device is capable of operating in either buried channel or inversion mode and wherein the normally off threshold voltage versus the transconductance can be tailored.

13. A vertical or lateral MOSFET comprising the silicon carbide semiconductor structure of claim 9.

14. A method of making a semiconductor structure comprising providing a drift layer having a first conductivity type, ion implanting a base or shielding layer having a second conductivity type overlying at least a portion of the drift layer, ion implanting a channel having the first conductivity type within the base or shielding layer and ion implanting a surface layer having the second conductivity type so that the surface layer overlies at least a portion of the base or shielding structure.

15. The method of claim 14, wherein the surface layer is implanted using implantation energies of from about 25keV to about 100keV
